# EUROPÄISCHE PATENTSCHRIFT

(11) **EP 4 257 935 B1**
(45) Veröffentlichungstag und Bekanntmachung des Hinweises auf die Patenterteilung: **10.12.2025**
(21) Anmeldenummer: 23166558.9
(22) Anmeldetag: 04.04.2023
(51) Int. Cl.: G01F 23/263, G01D 11/24

(54) **MESSGERÄT ZUR KAPAZITIVEN GRENZSTANDSERFASSUNG**
MEASURING DEVICE FOR CAPACITIVE DETECTION OF A LIMIT LEVEL
APPAREIL DE MESURE POUR LA DÉTECTION CAPACITIVE DE NIVEAU LIMITE

(30) Priorität: 08.04.2022 DE 102022108591
(43) Veröffentlichungstag der Anmeldung: 11.10.2023
(73) Patentinhaber: ifm electronic gmbh, 45128 Essen (DE)
(72) Erfinder: Liehr, Sebastian, 88099 Neukirch (DE)
(74) Vertreter: Ifm Patentabteilung

(56) Entgegenhaltungen:
- DE-A1- 102012 025 518
- DE-A1- 102017 200 414
- DE-A1- 102020 204 517
- DE-U1- 202014 103 822

## Beschreibung

Die Erfindung betrifft ein Messgerät zur kapazitiven Grenzstandserfassung gemäß dem Oberbegriff von Anspruch 1.

Kapazitiv arbeitende Messgeräte zur Grenzstandserfassung, die das Vorhandensein bzw. Nichtvorhandensein eines bestimmten Füllstandes eines Mediums ermitteln, sind bekannt, bspw. aus der DE 102007059709 A1. Sie bestehen im Wesentlichen aus einem Gehäuse und einer sich in axialer Richtung unmittelbar an das Gehäuse anschließenden Sensorspitze. In der Sensorspitze ist oft nur eine Elektrode des Messkondensators ausgebildet und die andere Elektrode des Messkondensators wird durch die Umgebung des kapazitiven Sensors bzw. Messgeräts gebildet. Der Messkondensator ist also im Regelfall kein Kondensator im Sinne eines vollständigen elektrotechnischen Bauelements, sondern eine mit einer Kapazität ausgestattete Anordnung, deren aktive Elektrode dem kapazitiven Sensor zugeordnet ist, wobei sich ein elektrisches Streufeld von der aktiven Elektrode in die Umgebung erstreckt. Um die Messelektrode als Sensor vor äußeren Einflüssen zu schützen ist sie von einer Ummantelung umgeben, die typischerweise aus einem Kunststoff besteht.

Bei den bekannten Grenzstandschaltern muss der Übergang der Kunststoffummantelung und dem Messgerätegehäuse insbesondere beim Einsatz in der Lebensmittelindustrie aus hygienischen Gründen abgedichtet werden, da die Sensorspitze vom Messgerät nicht oder nicht ohne Weiteres demontierbar ist und somit beide Teile nicht separat reinigbar sind.

Im Stand der Technik werden die beiden Teile entweder miteinander verklebt oder die Dichtigkeit wird mit Hilfe eines Dichtungsrings, insbesondere eines O-Rings erreicht. Beides verursacht nicht unerhebliche Kosten, insbesondere aufgrund des höheren Fertigungsaufwands. Im Fall einer Klebung ist zudem auch die Auswahl des Klebers stark eingeschränkt, da die Konformität mit bestimmten Normen und Zulassungen einzuhalten ist. Bei der Abdichtung mittels O-Ring ergeben sich Nachteile in der mechanischen Stabilität, da sich durch die O-Ring-Nut die Auflagefläche zwischen Kunststoffummantelung und Sensorgehäuse verringert. Eine konstruktive Behebung dieses Nachteils verursacht jedoch erheblichen Mehraufwand. DE102017200414A1 offenbart ein kapazitives Messgerät zur Grenzstandserfassung, bei dem die Sensorkappe mittels O-Ringen gegen das Gehäuse abgedichtet wird.

Aus der DE 102012203400 B4 der Anmelderin ist bekannt, dass das Gehäuse am äußersten Rand der Berührungsfläche mit der Ummantelung der Sensorspitze eine axial gerichtete krallenartige Erhebung aufweist und zur Herstellung einer dichten Verbindung zwischen Gehäuse und Sensorspitze diese krallenartige Erhebung die Kunststoffummantelung in einem quasi linienförmigen Bereich berührt. Auf diese Weise wird die Verbindung zwischen Gehäuse und Kunststoffummantelung ohne zusätzlichem Dichtelement oder Klebemittel hergestellt und dabei eine totraumfreie und sehr gut reinigbare Abdichtung zwischen beiden Teilen realisiert.

Die Materialeigenschaften der Kunststoffsensorspitze setzen jedoch Grenzen bzgl. Temperaturbeständigkeit. Hochleistungskunststoffe ermöglichen einen Einsatz bei einer Prozesstemperatur bis ca. 150°C.

Aufgabe der Erfindung ist es, eine dauerhaft dichte Verbindung zwischen Messgerätegehäuse und Ummantelung der Sensorspitze vorzuschlagen, die für verschiedene Materialien der Ummantelung geeignet und auch bei einem Hochtemperatureinsatz über 150°C hinaus beständig ist.

Die Aufgabe wird durch ein Messgerät mit den Merkmalen des Anspruchs 1 gelöst. Vorteilhafte Ausgestaltungen der Erfindung sind in den Unteransprüchen angegeben.

Erfindungsgemäß weist das Gehäuse des Messgeräts eine nach innen gerichtete schulterartige Verschmälerung auf, auf der ein Ringelement aufliegt. Andererseits weist die Ummantelung auf Höhe der schulterartigen Verschmälerung eine nutartige Vertiefung auf. In diese Vertiefung greift das Ringelement ein.

Entscheidend dabei ist zum einen, dass das Ringelement derart ausgebildet ist, dass es eine dauerhafte Zugspannung nach innen in Richtung der nutartigen Vertiefung entwickelt. Zum anderen ist für die Erfindung wesentlich, dass die nutartige Vertiefung eine Keilform aufweist, d.h. eine Schräge, die der schulterartigen Verschmälerung gegenüberliegt, um die radial wirkende Zugspannung in eine axiale Kraftwirkung umzulenken. Wenn es das Ringelement nach innen zieht wird durch die Schräge der nutartigen Vertiefung die Ummantelung axial in Richtung des Gehäuses gezogen, so dass das Gehäuse dauerhaft dicht auf dem Vorsprung der Ummantelung aufliegt.

Bevorzugt handelt es sich bei dem Ringelement um einen Sprengring, der gegenüber seinem ursprünglichen Durchmesser aufgeweitet ist und dadurch die dauerhafte Zugspannung nach innen in Richtung der nutartigen Vertiefung entwickelt.

In einer alternativen bevorzugten Ausführungsform ist das Ringelement als Ring mit nach innen gerichteten zackenartigen Haltezungen ausgeführt, wobei diese Haltezungen derart vorgespannt sind, dass dadurch die dauerhafte Zugspannung nach innen in Richtung der nutartigen Vertiefung entwickelt wird. Dieser Ring mit nach innen gerichteten zackenartigen Haltezungen ist beispielsweise als geschlitzte Tellerfeder, als doppelt geschlitzte Scheibenfeder oder als Kugellager-Tellerfeder ausgeführt.

Vorteilhafterweise ist das das Ringelement als Dreieckring ausgeführt und weist dabei insbesondere eine trilobiulare Kontur auf. Dies ermöglicht auch eine Abstützung des Ringelements nach außen und verbessert dadurch die Klemmung im Gehäuse. Außerdem wird dadurch die Demontage der Sensorspitze bzw. der Ummantelung aus dem Gehäuse erleichtert.

Für einen Hochtemperatureinsatz besteht die Ummantelung vorzugsweise aus einem keramischen Werkstoff, während das Messgerätgehäuse typischerweise aus Edelstahl gefertigt ist.

Für eine optimale Kraftumlenkung weist die Keilform der nutartigen Vertiefung vorzugsweise einen Winkel von etwa 30° auf.

Der Clou ist die Kraftumlenkung und Nutgeometrie in Verwendung von Stahl- und Keramikwerkstoffen. Die Erfindung unterscheidet sich durch eine neue Verbindungstechnik und durch Verwendung eines hochtemperaturstabilen Werkstoffes der Sensorspitze.

Ein klassischer Sprengring dient im Maschinenbau mehr oder weniger nur als Verlier-Sicherung oder Positionierhilfe. Erfindungsgemäß wird die ursprüngliche Eigenschaft des Sprengrings, seiner radial wirkenden Federkraft zum Klemmen auf einem größeren oder in einem kleineren Durchmesser, durch geschickte Nutauslegung in eine axiale Zugkraft umgeleitet. Somit lassen sich sehr einfache und kostenmünstine Geometrien verwenden. So kann bspw. auf ein Gewinde, eine hochgenaue Presspassung oder eine nachträgliche Fräsung für einen Nutenstein verzichtet werden.

Durch die Kombination aus einer keramischen Sensorspitze und einem einfachen metallischen Verbindungselement in Form des Sprengrings ist ein Einsatz des Messgeräts bei Prozesstemperaturen von über 250 °C möglich. Gleichzeitig lässt sich die Erfindung durch eine einfache Montage, der Verwendung eines sehr günstigen Verbindungselements und einer vergleichsweise einfachen Herstellung der Fügepartner kostengünstig realisieren und die Verbindung zwischen Ummantelung und Gehäuse ist aufgrund der Vorspannung dauerhaft dicht und langlebig.

Nachfolgend wird die Erfindung anhand von Ausführungsbeispielen unter Bezugnahme auf die Zeichnungen näher erläutert.

Es zeigen schematisch:
- Figur 1: ein erfindungsgemäßes Messgerät zur kapazitiven Grenzstandserfassung,
- Figur 2: ein Schnittbild des erfindungsgemäßen Messgeräts aus Fig. 1,
- Figur 3: einen vergrößerten Ausschnitt eines Teilbereichs aus Fig. 2 und
- Figur 4: einen vergrößerten Ausschnitt eines Teilbereichs aus Fig. 3.

Bei der nachfolgenden Beschreibung einer bevorzugten Ausführungsform bezeichnen gleiche Bezugszeichen gleiche oder vergleichbare Komponenten.

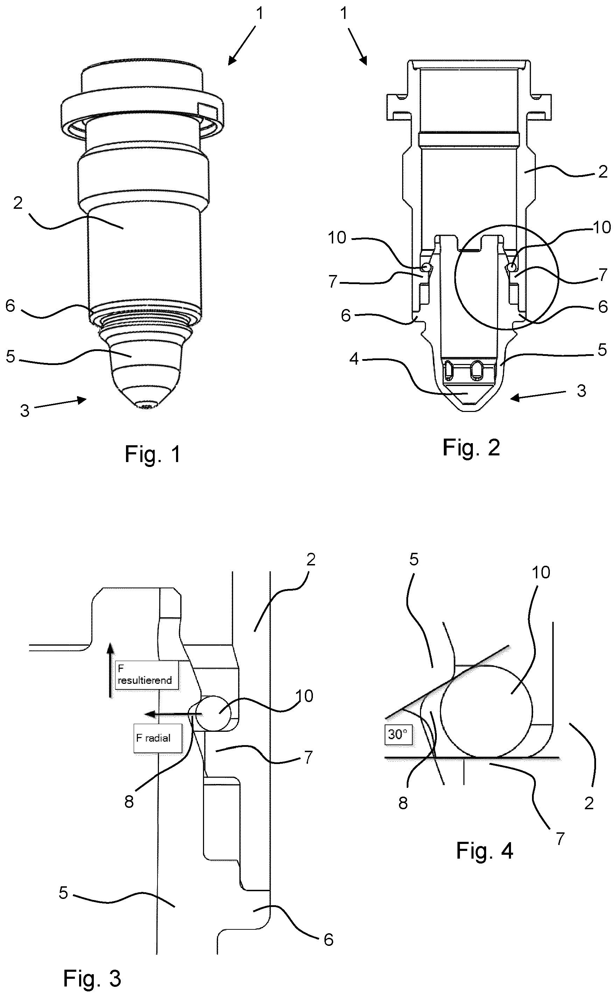

Fig. 1 zeigt ein erfindungsgemäßes Messgerät 1 zur kapazitiven Grenzstandserfassung. Das Messgerät 1 wird vorzugsweise in einen nicht weiter dargestellten Adapter eingeschraubt und besitzt daher ein zumindest teilweise rotationssymmetrisches Gehäuse 2. Am vorderen Ende des Messgeräts 1, axial unmittelbar an das Gehäuse 2 angeschlossen, befindet sich die Sensorspitze 3, die im Wesentlichen aus einer Messelektrode 4 und einer die Messelektrode 4 umgebenden Ummantelung 5 besteht. Mit Hilfe der Messelektrode 4 kann gegen ein Bezugspotential eine Kapazität gemessen werden, was letztlich zur Bestimmung eines Grenzwertes eines Füllstands ausgewertet werden kann. Die Ummantelung 5 weist einen den Durchmesser der Sensorspitze 3 vergrößernden Vorsprung 6 auf, auf den das Gehäuse 2 axial aufsetzt. Für den Hochtemperatureinsatz besteht die Ummantelung 5 aus einem keramischen Werkstoff. Es sind aber bei geringeren Prozesstemperaturen grundsätzlich auch andere Materialien denkbar, vor allem thermoplastische Kunststoffe, insbesondere Polyetheretherketon (PEEK) oder modifiziertes Polytetrafluorethylen (PTFE).

In Fig. 2, das ein Schnittbild des Messgeräts 1 aus Fig. 1 darstellt, ist das Innenleben des Messgeräts 1 zu erkennen. Die Ummantelung 5 umhüllt die Messelektrode 4 und erstreckt sich weit in das Gehäuse 2 hinein. Zu erkennen ist des Weiteren der umlaufende Vorsprung 6, auf den das Gehäuse 2 axial aufsetzt.

Oberhalb des Vorsprungs 6 weist das Gehäuse 2 in seinem unteren Bereich eine umlaufende, nach innen gerichtete schulterartige Verschmälerung 7 auf, auf der ein Sprengring 10 aufliegt. Zu erkennen ist, dass die Ummantelung 5 eine nutartige Vertiefung 8 aufweist, in die der Sprengring 10 eingreift und so die Ummantelung eine Art Widerhaken ausbildet. Dieser Widerhaken hindert die Ummantelung 5 und damit die gesamte Sensorspitze 3 daran, aus dem Gehäuse 2 herauszufallen. Dieser für die Erfindung relevante eingekreiste Bereich ist in den nachfolgenden Figuren vergrößert dargestellt.

Die Ausführung mit Sprengring 10 stellt eine bevorzugte Ausführungsform dar. Vom Schutzbereich mit umfasst sind statt des Sprengrings auch andere denkbare Ringelemente, die derart ausgebildet sind, dass sie eine dauerhafte Zugspannung nach innen in Richtung der nutartigen Vertiefung 8 entwickeln können. Insbesondere sind hierbei Ringe mit nach innen gerichteten zackenartigen Haltezungen gemeint, bspw. geschlitzte Tellerfeder, doppelt geschlitzte Scheibenfeder oder Kugellager-Tellerfeder.

Fig. 3 zeigt den in Fig. 2 eingekreisten Bereich in vergrößerter Darstellung. Im Fokus der Erfindung steht die dauerhaft dichte Verbindung des Messgerätgehäuses 2 mit der Ummantelung 5, d.h. an der Stelle, wo das Gehäuse 2 auf dem Vorsprung 6 der Ummantelung 5 aufsetzt. Auf der bereits beschriebenen umlaufenden, nach innen gerichteten Verschmälerung 7 liegt der Sprengring 10 auf. Auf Höhe der Verschmälerung 7 weist die Ummantelung 5 die erwähnte nutartige Vertiefung 8 auf, in die der Sprengring 10 eingreift. Der obere Teil der nutartigen Vertiefung 8 liegt auf dem Sprengring 10 auf, so dass die gesamte Ummantelung 5 und damit die Sensorspitze an sich zwischen dieser Auflage auf dem Sprengring 10 und dem gegen das Gehäuse 2 drückenden Vorsprung 6 in beide Richtungen axial fixiert ist.

Um Toleranzen auszugleichen und Temperatureinflüssen entgegenzuwirken ist diese axiale Fixierung in einem gewissen Maße variabel. Das wird dadurch erreicht, dass zum einen der Sprengring 10 gegenüber seinem ursprünglichen Durchmesser aufgeweitet ist und dadurch eine dauerhafte Zugspannung nach innen in Richtung der nutartigen Vertiefung 8 entwickelt und zum anderen der die nutartige Vertiefung 8 eine Keilform aufweist. Keilform bedeutet, dass die Vertiefung 8 keine klassische runde Nutform mit einem nahezu senkrecht zur Längsachse des Messgeräts 1 verlaufenden oberen Anschlag aufweist, sondern dass der obere Teil der Vertiefung 8 eine schräg verlaufende Form aufweist, so dass sich die Vertiefung 8 nach außen hin aufweitet. Durch diese besondere Ausgestaltung der Vertiefung 8 wird die Ummantelung 5 aufgrund der nach Innen wirkenden Zugspannung des Sprengrings 10 axial in Richtung des Gehäuses 2 gezogen, so dass das Gehäuse 2, das hierbei einen Anschlag für diese Bewegung darstellt, dauerhaft dicht auf dem Vorsprung 6 der Ummantelung 5 aufliegt. Entscheidend ist also die Umlenkung der radial wirkenden Zugspannung des Sprengring 10 in eine axiale Kraft, was durch die Pfeile veranschaulicht ist.

In Fig. 4 ist der Bereich der nutartigen Vertiefung 8 nochmals vergrößert dargestellt. Durch die zwei dargestellten Linien soll die Keilform der Vertiefung 8 zum Ausdruck kommen. Es hat sich herausgestellt, dass für eine optimale Kraftumlenkung die Keilform der nutartigen Vertiefung 8 einen Öffnungswinkel von etwa 30° aufweisen sollte. Selbstverständlich sind auch andere Winkel möglich und die Erfindung nicht auf diese Ausführung beschränkt.

### Bezugszeichenliste

- 1: Messgerät
- 2: Gehäuse des Messgeräts
- 3: Sensorspitze
- 4: Messelektrode
- 5: Ummantelung
- 6: Vorsprung
- 7: Verschmälerung
- 8: nutartige Vertiefung
- 10: Sprengring

## Patentansprüche

1. Messgerät (1) zur kapazitiven Grenzstandserfassung, bestehend aus
- einem zumindest teilweise rotationssymmetrischen Gehäuse (2) und
- einer sich in axialer Richtung unmittelbar an das Gehäuse (2) anschließenden Sensorspitze (3), die eine Messelektrode (4) und eine die Messelektrode (4) umgebende Ummantelung (5) umfasst,
wobei sich die Ummantelung (5) in das Gehäuse (2) hinein erstreckt und einen umlaufenden, den Durchmesser der Sensorspitze (3) vergrößernden Vorsprung (6) aufweist, auf den das Gehäuse (2) axial aufsetzt,
**dadurch gekennzeichnet,**
**dass** das Gehäuse (2) eine nach innen gerichtete schulterartige Verschmälerung (7) aufweist, auf der ein Ringelement (10) aufliegt, und dass die Ummantelung (5) auf Höhe der schulterartigen Verschmälerung (7) eine nutartige Vertiefung (8) aufweist, in die das Ringelement (10) eingreift,
wobei das Ringelement (10) derart ausgebildet ist, dass es eine dauerhafte Zugspannung nach innen in Richtung der nutartigen Vertiefung (8) entwickelt, und wobei die nutartige Vertiefung (8) eine Keilform aufweist, dergestalt, dass die Ummantelung (5) aufgrund der nach Innen wirkenden Zugspannung des Ringelements (10) axial in Richtung des Gehäuses (2) gezogen wird und dadurch das Gehäuse (2) dauerhaft dicht auf dem Vorsprung (6) der Ummantelung (5) aufliegt.

2. Messgerät nach Anspruch 1,
**dadurch gekennzeichnet, dass** das Ringelement (10) als Sprengring ausgeführt ist, der gegenüber seinem ursprünglichen Durchmesser aufgeweitet ist und dadurch die dauerhafte Zugspannung nach innen in Richtung der nutartigen Vertiefung (8) entwickelt.

3. Messgerät nach Anspruch 1,
**dadurch gekennzeichnet, dass** das Ringelement (10) als Ring mit nach innen gerichteten zackenartigen Haltezungen ausgeführt ist, wobei diese Haltezungen vorgespannt sind und dadurch die dauerhafte Zugspannung nach innen in Richtung der nutartigen Vertiefung (8) entwickeln.

4. Messgerät nach Anspruch 3,
**dadurch gekennzeichnet, dass** der Ring mit nach innen gerichteten zackenartigen Haltezungen als geschlitzte Tellerfeder, als doppelt geschlitzte Scheibenfeder oder als Kugellager-Tellerfeder ausgeführt ist.

5. Messgerät nach einem der vorhergehenden Ansprüche,
**dadurch gekennzeichnet, dass** das Ringelement (10) als Dreieckring ausgeführt ist.

6. Messgerät nach Anspruch 5,
**dadurch gekennzeichnet, dass** der Dreieckring eine trilobulare Kontur aufweist.

7. Messgerät nach einem der vorhergehenden Ansprüche,
**dadurch gekennzeichnet, dass** die Ummantelung (5) aus Keramik besteht.

8. Messgerät nach einem der vorhergehenden Ansprüche,
**dadurch gekennzeichnet, dass** die Keilform der nutartigen Vertiefung (8) einen Winkel von 30° aufweist.

## Claims

1. Measuring device (1) for capacitive point level detection, consisting of
- an at least partially rotationally symmetrical housing (2) and
- a sensor tip (3) which is directly connected to the housing (2) in the axial direction and which comprises a measuring electrode (4) and a casing (5) surrounding the measuring electrode (4), the casing (5) extending into the housing (2) and having a circumferential projection (6) which increases the diameter of the sensor tip (3) and on which the housing (2) rests axially,
**characterized**
**in that** the housing (2) has an inwardly directed shoulder-like narrowing (7) on which a ring element (10) rests, and **in that** the casing (5) has a groove-like recess (8) at the level of the shoulder-like narrowing (7), in which recess the ring element (10) engages, the ring element (10) being designed such that it develops a permanent tensile stress inward, toward the groove-like recess (8), and the groove-like recess (8) having a wedge shape such that the casing (5) is pulled axially toward the housing (2) due to the inwardly acting tensile stress of the ring element (10), and as a result the housing (2) rests in a permanently seal-tight manner on the projection (6) of the casing (5).

2. Measuring device according to claim 1,
**characterized in that** the ring element (10) is designed as a snap ring which is expanded compared to its original diameter and thereby develops the permanent tensile stress inward, toward the groove-like recess (8).

3. Measuring device according to claim 1,
**characterized in that** the ring element (10) is designed as a ring having inwardly directed tooth-like retaining tongues, these retaining tongues being prestressed and as a result developing the permanent tensile stress inward, toward the groove-like recess (8).

4. Measuring device according to claim 3,
**characterized in that** the ring having inwardly directed tooth-like retaining tongues is designed as a slotted disk spring, as a double-slotted disk spring or as a ball bearing disk spring.

5. Measuring device according to any one of the preceding claims,
**characterized in that** the ring element (10) is designed as a triangular ring.

6. Measuring device according to claim 5,
**characterized in that** the triangular ring has a trilobular contour.

7. Measuring device according to any one of the preceding claims,
**characterized in that** the casing (5) is made of ceramic.

8. Measuring device according to any one of the preceding claims,
**characterized in that** the wedge shape of the groove-like recess (8) has an angle of 30°.

## Revendications

1. Appareil de mesure (1) pour la détection capacitive de niveau limite, composé de
- un boîtier (2) à symétrie de révolution au moins partielle, et
- une pointe de capteur (3) reliée directement au boîtier (2) dans la direction axiale, laquelle pointe de capteur comprend une électrode de mesure (4) et une enveloppe (5) entourant l'électrode de mesure (4), dans lequel l'enveloppe (5) s'étend dans le boîtier (2) et présente une saillie (6) circonférentielle augmentant le diamètre de la pointe de capteur (3), saillie sur laquelle le boîtier (2) repose axialement,
**caractérisé en ce**
**que** le boîtier (2) présente un rétrécissement en forme d'épaulement (7) dirigé vers l'intérieur sur lequel repose un élément annulaire (10), et **en ce que** l'enveloppe (5) présente, à hauteur du rétrécissement en forme d'épaulement (7), un renfoncement en forme de rainure (8) dans lequel l'élément annulaire (10) vient en prise, dans lequel l'élément annulaire (10) est conçu de telle manière qu'il développe une contrainte de traction permanente vers l'intérieur en direction du renfoncement en forme de rainure (8), et dans lequel le renfoncement en forme de rainure (8) présente une forme de coin de telle sorte que l'enveloppe (5) est tirée axialement en direction du boîtier (2) en raison de la contrainte de traction agissant vers l'intérieur de l'élément annulaire (10) et que le boîtier (2) repose ainsi en permanence de manière étanche sur la saillie (6) de l'enveloppe (5).

2. Appareil de mesure selon la revendication 1,
**caractérisé en ce que** l'élément annulaire (10) est réalisé sous forme d'anneau d'arrêt qui est élargi par rapport à son diamètre initial et qui développe ainsi la contrainte de traction permanente vers l'intérieur en direction du renfoncement en forme de rainure (8).

3. Appareil de mesure selon la revendication 1,
**caractérisé en ce que** l'élément annulaire (10) est réalisé sous forme d'anneau comportant des languettes de maintien en forme de dents dirigées vers l'intérieur, dans lequel lesdites languettes de maintien sont précontraintes et développent ainsi la contrainte de traction permanente vers l'intérieur en direction du renfoncement en forme de rainure (8).

4. Appareil de mesure selon la revendication 3,
**caractérisé en ce que** l'anneau comportant des languettes de maintien en forme de dents dirigées vers l'intérieur est réalisé sous forme de rondelle-ressort fendue, de clavette disque à double fente ou de rondelle-ressort à roulement à billes.

5. Appareil de mesure selon l'une des revendications précédentes,
**caractérisé en ce que** l'élément annulaire (10) est réalisé sous forme d'anneau triangulaire.

6. Appareil de mesure selon la revendication 5,
**caractérisé en ce que** l'anneau triangulaire présente un contour trilobé.

7. Appareil de mesure selon l'une des revendications précédentes,
**caractérisé en ce que** l'enveloppe (5) est en céramique.

8. Appareil de mesure selon l'une des revendications précédentes,
**caractérisé en ce que** la forme de coin du renfoncement en forme de rainure (8) présente un angle de 30°.
